# EUROPEAN PATENT SPECIFICATION

(11) **EP 2 721 651 B1**
(45) Date of publication and mention of the grant of the patent: **04.04.2018**
(21) Application number: 12800673.1
(22) Date of filing: 15.06.2012
(51) Int. Cl.: H01L 33/42, H01L 33/22, C23C 14/08, C23C 14/30

(54) **METHOD FOR FORMING CURRENT DIFFUSION LAYER IN SEMICONDUCTOR LIGHT EMITTING DEVICE AND METHOD FOR FABRICATING SEMICONDUCTOR LIGHT EMITTING DEVICE**
VERFAHREN ZUR HERSTELLUNG EINER STROMDIFFUSIONSSCHICHT IN EINER LICHTEMITTIERENDEN HALBLEITERVORRICHTUNG UND VERFAHREN ZUR HERSTELLUNG EINER LICHTEMITTIERENDEN HALBLEITERVORRICHTUNG
PROCÉDÉ DE FORMATION D'UNE COUCHE DE DIFFUSION DE COURANT DANS UN DISPOSITIF ÉLECTROLUMINESCENT SEMI-CONDUCTEUR ET PROCÉDÉ DE FABRICATION D'UN DISPOSITIF ÉLECTROLUMINESCENT SEMI-CONDUCTEUR

(30) Priority: 17.06.2011 CN 201110163904
(43) Date of publication of application: 23.04.2014
(73) Proprietor: Shenzhen BYD Auto R&D Company Limited, Shenzhen, Guangdong 518118 (CN); BYD Company Limited, Shenzhen, Guangdong 518118 (CN)
(72) Inventor: CHEN, Wanshi, Shenzhen Guangdong 518118 (CN); ZHANG, Wang, Shenzhen Guangdong 518118 (CN)
(74) Representative: Hoffmann Eitle
(86) International application number: PCT/CN2012/077035
(87) International publication number: WO 2012/171493

(56) References cited:
- CN-A- 101 075 652
- CN-A- 101 740 704
- CN-A- 101 764 186
- CN-A- 101 931 034
- CN-A- 101 964 382
- CN-Y- 2 813 637
- JP-A- 2001 203 393
- JP-A- 2005 217 331
- JP-A- 2011 060 986
- US-A1- 2005 001 224
- US-A1- 2005 277 218
- US-A1- 2008 296 598
- PENG ZHAN, ZHENCAO LI AND ZHENGJUN ZHANG: "Preparation of Highly Textured ZnO Thin Films by Pulsed Electron Deposition", MATERIALS TRANSACTIONS, vol. 52, no. 9, 25 August 2011 (2011-08-25), pages 1764-1767, XP002730403, The Japan Institute of Metals

## Description

### FIELD

The present disclosure belongs to the field of an LED chip, and more particularly relates to a method for forming a current diffusion layer in a semiconductor light emitting device and a method for fabricating a semiconductor light emitting device.

### BACKGROUND

Currently, ITO (indium-tin oxide) as a current diffusion layer has been widely applied in the fabrication of an LED chip, however, the light extraction efficiency of the LED chip is still undesirable. A commonly used method is to roughen the surface of an ITO layer so as to enhance the light extraction efficiency of the LED chip. In the prior art, the method for roughening the surface of the ITO layer mainly comprises a dry etching method and a wet etching method. The dry etching method mainly comprises steps of forming the ITO layer, forming a mask pattern using a photoresist, and etching an ITO region which is not protected by the photoresist using ICP (inductive couple plasmas), so as to achieve the roughening of the surface of the ITO layer. The wet etching comprises steps of coating a layer of nanoparticles on the surface of the ITO layer as a protective layer, and corroding an ITO region which is not protected by the nanoparticles using a corrosion solution such as an acid solution, so as to achieve the roughening of the surface of the ITO layer. However, the two methods both belong to an ectopic roughening method, that is, a product needs to be transferred onto other apparatuses for roughening. Therefore, expensive apparatuses (such as a lithography equipment and an ICP equipment) need to be used, and because an acidic corrosion solution is used, there may be potential safety risks.

CN 101931034 is related to a photovoltaic element comprising a semiconductor laminate, a first transparent conductive oxide layer located on the semiconductor laminate and a second transparent conductive oxide layer covering the first transparent oxide layer. These layers are formed by electron beam evaporation by a sputtering deposition technique.

CN 20813637 is related to a horizontal electron beam evaporation type vacuum filming machine wherein an electron beam evaporation gun is arranged in a work piece rack. A rotary shaft of the work piece rack is the horizontal direction.

US 2005/0001224 describes a light-emitting diode and a method for its manufacturing. According to the method a growth substrate is provided wherein a buffer layer and an etching stop layer are stacked on the growth substrate in sequence, a semiconductor epitaxial structure is formed on the etching stop layer, the growth substrate, the buffer layer and the etching stop layer are removed, a transparent substrate is provided wherein a surface of the transparent substrate comprises a reflective layer and the other surface of the transparent substrate comprises a solder layer. Then a wafer bonding step is performed and a transparent conductive layer is formed to cover the semiconductor epitaxial structure.

### SUMMARY

Embodiments of the present disclosure seek to solve at least one of the problems existing in the prior art to at least some extent, or to provide a consumer with a useful commercial choice. Accordingly, a method for forming a current diffusion layer in a semiconductor light emitting device and a method for fabricating a semiconductor light emitting device are provided. Roughening of the ITO layer is completed during the process of forming the ITO layer, and a product does not need to be transferred onto other apparatuses for roughening, thus shortening the production cycle and reducing the production cost. Meanwhile, the corrosion solution does not need to be used, thus providing security.

According to embodiments of a first broad aspect of the present disclosure, there is provided a method for forming a current diffusion layer in a semiconductor light emitting device. The method comprises steps of:
S11) heating and evaporating an ITO source on an epitaxial wafer by a direct current electron gun to form an ITO layer;
S12) after a part of the ITO layer which accounts for 85%-90% of the thickness of the ITO layer is deposited, heating and evaporating a doped ZnO source by a pulse current electron gun, and controlling a duty ratio of the pulse current of the pulse current electron gun to deposit a discontinuously arranged doped ZnO layer on the part of the ITO layer during the process of depositing the ITO layer, in which a deposition rate of the doped ZnO layer is larger than that of the ITO layer; and
S13) after the doped ZnO layer is deposited, further heating and evaporating the ITO source by the direct current electron gun to continue depositing a continuously deposited ITO layer which buries the doped ZnO layer.

According to embodiments of a second broad aspect of the present disclosure, there is provided a method for fabricating a semiconductor light emitting device. The method comprises steps of:
S21) heating and evaporating an ITO source on an epitaxial wafer by a direct current electron gun to form an ITO layer;
S22) after a part of the ITO layer which accounts for 85%-90% of the thickness of the ITO layer is deposited, heating and evaporating a doped ZnO source by a pulse current electron gun, and controlling a duty ratio of the pulse current of the pulse current electron gun to deposit a discontinuously arranged doped ZnO layer on the part of the ITO layer during the process of depositing the ITO layer, in which a deposition rate of the doped ZnO layer is larger than that of the ITO layer;
S23) after the doped ZnO layer is deposited, further heating and evaporating the ITO source by the direct current electron gun to continue depositing a continuously deposited ITO layer which buries the doped ZnO layer;
S24) forming a photoresist protective layer on the ITO layer, etching the ITO layer and the doped ZnO layer on a step region of the epitaxial wafer which are not protected by the photoresist, and removing the photoresist protective layer; and
S25) forming a positive electrode of the semiconductor light emitting device on a current diffusion layer constituted by the ITO layer and the doped ZnO layer, and forming a negative electrode of the semiconductor light emitting device on the step region of the epitaxial wafer.

With the method for forming the current diffusion layer in the semiconductor light emitting device and the method for fabricating the semiconductor light emitting device according to an embodiment of the present disclosure, the roughening of the ITO layer is completed during the process of forming the ITO layer. The method for roughening the ITO layer belongs to an in situ roughening method, and a product does not need to be transferred onto other apparatuses for roughening, thus shortening the production cycle and reducing the production cost. That is, additional apparatuses and materials, for example, a photoresist, a lithography equipment and an ICP equipment which are used during dry etching as well as a corrosion apparatus and a corrosion solution which are used during wet etching, do not need to be used for roughening the ITO layer. Meanwhile, because the corrosion solution does not need to be used, the personal safety of employees may be ensured, thus providing security.

Additional aspects and advantages of embodiments of present disclosure will be given in part in the following descriptions, become apparent in part from the following descriptions, or be learned from the practice of the embodiments of the present disclosure.

### BRIEF DESCRIPTION OF THE DRAWINGS

These and other aspects and advantages of embodiments of the present disclosure will become apparent and more readily appreciated from the following descriptions made with reference to the accompanying drawings, in which:
Fig.1 is a flow chart of a method for forming a current diffusion layer in a semiconductor light emitting device according to an embodiment of the present disclosure;
Fig. 2 is a cross-sectional view of an epitaxial wafer according to an embodiment of the present disclosure;
Fig. 3 is a cross-sectional view of an epitaxial wafer formed with a step region according to an embodiment of the present disclosure;
Fig. 4 is a cross-sectional view of an intermediate status of a semiconductor light emitting device formed with an ITO layer according to an embodiment of the present disclosure;
Fig. 5 is a cross-sectional view of an intermediate status of a semiconductor light emitting device formed with a doped ZnO layer on an ITO layer according to an embodiment of the present disclosure;
Fig. 6 is a cross-sectional view of an intermediate status of a semiconductor light emitting device formed with an ITO layer and a doped ZnO layer according to an embodiment of the present disclosure;
Fig. 7 is a cross-sectional view of an intermediate status of a semiconductor light emitting device after a current diffusion layer on a step region of an epitaxial wafer is etched according to an embodiment of the present disclosure;
Fig. 8 is a cross-sectional view of a semiconductor light emitting device according to an embodiment of the present disclosure; and
Fig. 9 is a cross-sectional view of a semiconductor light emitting device formed with a passivation layer according to an embodiment of the present disclosure.

### DETAILED DESCRIPTION

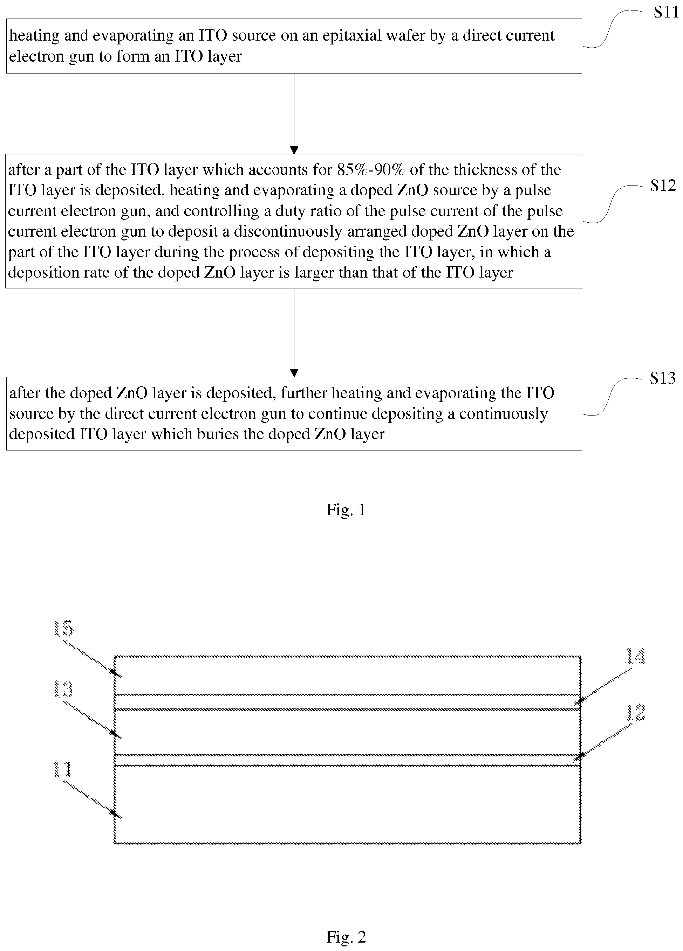

Fig.1 is a flow chart of a method for forming a current diffusion layer in a semiconductor light emitting device according to an embodiment of the present disclosure. As shown in Fig. 1, the method comprises steps of:
S11) heating and evaporating an ITO source on an epitaxial wafer by a direct current electron gun to form an ITO layer;
S12) after a part of the ITO layer which accounts for 85%-90% of the thickness of the ITO layer is deposited, heating and evaporating a doped ZnO source by a pulse current electron gun, and controlling a duty ratio of the pulse current of the pulse current electron gun to deposit a discontinuously arranged doped ZnO layer on the part of the ITO layer during the process of depositing the ITO layer, in which a deposition rate of the doped ZnO layer is larger than that of the ITO layer; and
S13) after the doped ZnO layer is deposited, further heating and evaporating the ITO source by the direct current electron gun to continue depositing a continuously deposited ITO layer which buries the doped ZnO layer.

With the method for forming the current diffusion layer in the semiconductor light emitting device according to an embodiment of the present disclosure, the roughening of the ITO layer is completed during the process of forming the ITO layer. The method for roughening the ITO layer belongs to an in situ roughening method, and a product does not need to be transferred onto other apparatuses for roughening, thus shortening the production cycle and reducing the production cost. That is, additional apparatuses and materials, for example, a photoresist, a lithography equipment and an ICP equipment which are used during dry etching as well as a corrosion apparatus and a corrosion solution which are used during wet etching, do not need to be used for roughening the ITO layer. Meanwhile, because the corrosion solution does not need to be used, the personal safety of employees may be ensured, thus providing security.

The method for forming the current diffusion layer in the semiconductor light emitting device according to an embodiment of the present disclosure will be described below in detail with reference to the drawings.

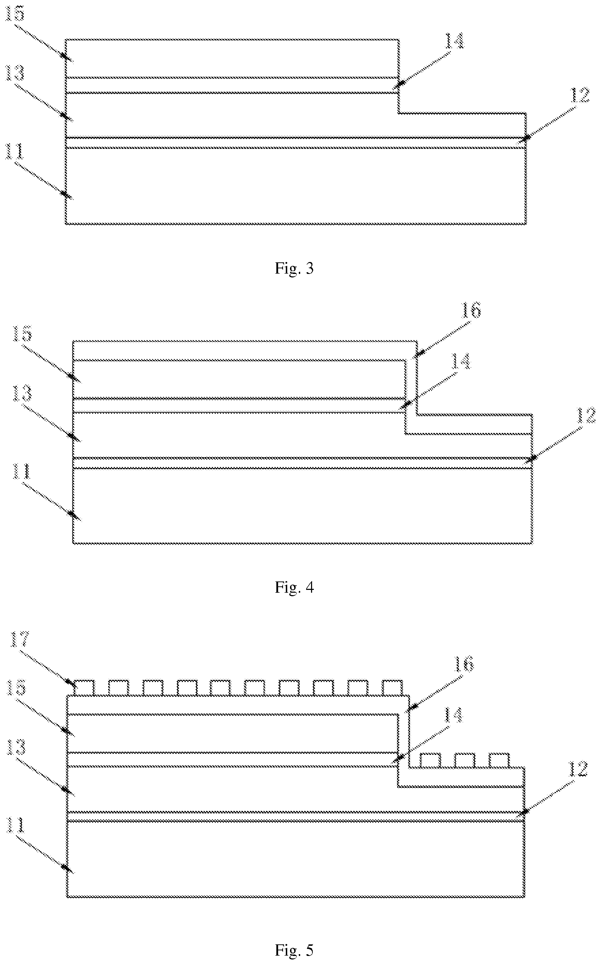

Referring to Fig. 4, particularly, in step S11) an ITO source is heated and evaporated on an epitaxial wafer by a direct current electron gun to form an ITO layer 16. The selection of the direct current electron gun and the technique of evaporating the ITO source to form the ITO layer are known to those skilled in the art, and therefore the description thereof will be omitted here.

Referring to Fig. 5, particularly, in step S12), after a part of the ITO layer 16 which accounts for 85%-90% of the thickness of the ITO layer 16 is deposited, a doped ZnO source is heated and evaporated by a pulse current electron gun, and a duty ratio of the pulse current of the pulse current electron gun is controlled to deposit a discontinuously arranged doped ZnO layer 17 on the part of the ITO layer 16 during the process of forming the ITO layer 16, in which a deposition rate of the doped ZnO layer 17 is larger than that of the ITO layer 16. In one embodiment, the thickness of the ITO layer 16 (i.e., the thickness of the current diffusion layer) is about 285 nanometers to about 290 nanometers. When the thickness of the part of the ITO layer 16 which accounts for 85%-90% of the thickness of the ITO layer 16 is about 250 nanometers to about 260 nanometers, the pulse current electron gun is turned on to heat and evaporate the doped ZnO source, and the duty ratio of the pulse current of the pulse current electron gun is controlled to deposit a discontinuously arranged doped ZnO layer 17 on the part of the ITO layer 16.

During the process of depositing the doped ZnO layer 17, the circuit of the pulse current electron gun is controlled to open or close rapidly by controlling the duty ratio of the pulse current of the pulse current electron gun. Therefore, the growth of a doped ZnO material mainly comprises discontinuous growth, so as to avoid continuous growth of the doped ZnO material and achieve discontinuous deposition of the doped ZnO material. As a result, the preparation of the discontinuously arranged doped ZnO layer 17 may be completed. In one embodiment, the growth of a doped ZnO material mainly comprises island growth. In one embodiment, the duty ratio of the pulse current is about 20% to about 30%. In one embodiment, the thickness of the doped ZnO layer 17 is about 10 nanometers to about 15 nanometers, thus achieving the roughening of the ITO layer 16. If the thickness of the doped ZnO layer 17 is larger than about 15 nanometers, the light extraction efficiency of the whole current diffusion layer may be reduced. If the thickness of the doped ZnO layer 17 is smaller than about 10 nanometers, the roughening of the ITO layer 16 may not be achieved.

Meanwhile, during the process of depositing the doped ZnO layer 17, the deposition rate of the doped ZnO layer 17 is larger than that of the ITO layer 16, that is, the ITO layer 16 is deposited by the direct current electron gun at a low speed, and the doped ZnO layer 17 is deposited by the pulse current electron gun at a high speed, thus ensuring that the doped ZnO layer 17 is effectively buried in the ITO layer 16. Meanwhile, during the process of depositing the doped ZnO layer 17, the ITO layer 16 is still deposited by the direct current electron gun at a low speed, thus better ensuring that the doped ZnO layer 17 is buried in the ITO layer 16. In one embodiment, the deposition rate of the ITO layer 16 formed by the direct current electron gun is about 0.5 Å/s to about 1.2 Å/s, and the deposition rate of the doped ZnO layer 17 formed by the pulse current electron gun is about 20 Å/s to about 30 Å/s.

In one embodiment, the doped ZnO source is at least one material selected from the group consisting of indium doped zinc oxide, gallium doped zinc oxide, aluminum doped zinc oxide, and a mixture of indium oxide and zinc oxide. Because the conductivity of these materials is substantially equivalent to the conductivity of ITO, when current diffusion layer is formed from ITO and at least one of these materials, the current may diffuse uniformly. Meanwhile, these materials and ITO are both transparent compounds, and the refractive index of these materials and the refractive index of ITO are approximate, which are both about 2.0. Therefore, light may not be easily refracted when penetrating through the ITO layer 16 and the doped ZnO layer 17, thus reducing the loss of light.

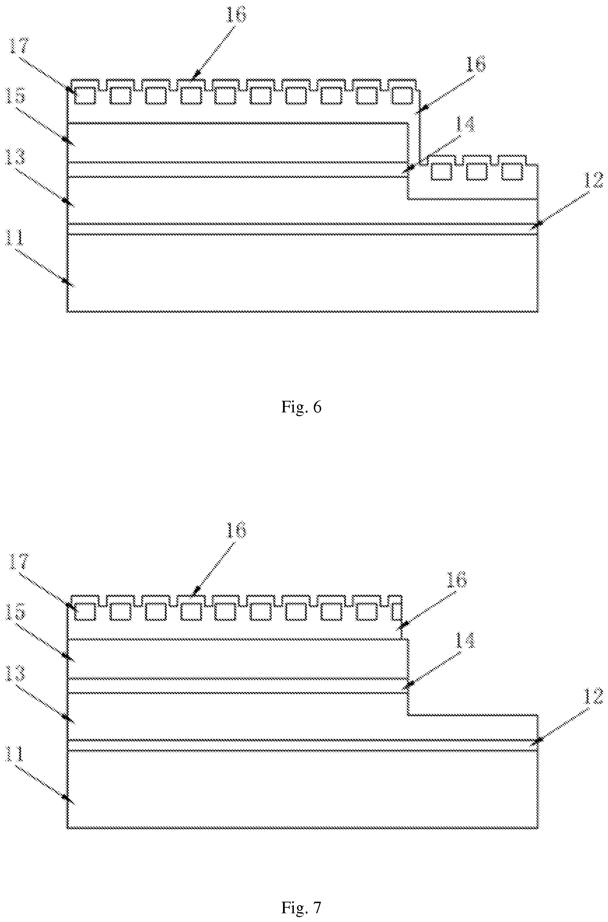

Referring to Fig. 6, particularly, in step S13), after the doped ZnO layer 17 is deposited, the ITO source is further heated and evaporated by the direct current electron gun to continue depositing a continuously deposited ITO layer 16 which buries the doped ZnO layer 17. In fact, in step S13), by continuously depositing the ITO layer 16, the doped ZnO layer 17 is completely buried in the ITO layer 16, so that there is a height difference between an ITO region in which the doped ZnO material is buried and another ITO region without the doped ZnO material. Therefore, the unevenness of the whole surface of the ITO layer 16 may be achieved, that is, the roughening of the ITO layer 16 may be achieved. In one embodiment, the thickness of the continuously deposited ITO layer 16 is about 15 nanometers to about 20 nanometers. It would be appreciated by those skilled in the art that the thickness of the continuously deposited ITO layer 16 is not limited to this, but may be varied, provided that the doped ZnO layer 17 is completely buried in the ITO layer 16.

According to an embodiment of the present disclosure, a method for fabricating a semiconductor light emitting device is provided. The method comprises steps of:
S21) heating and evaporating an ITO source on an epitaxial wafer by a direct current electron gun to form an ITO layer;
S22) after a part of the ITO layer which accounts for 85%-90% of the thickness of the ITO layer is deposited, heating and evaporating a doped ZnO source by a pulse current electron gun, and controlling a duty ratio of the pulse current of the pulse current electron gun to deposit a discontinuously arranged doped ZnO layer on the part of the ITO layer during the process of depositing the ITO layer, in which a deposition rate of the doped ZnO layer is larger than that of the ITO layer;
S23) after the doped ZnO layer is deposited, further heating and evaporating the ITO source by the direct current electron gun to continue depositing a continuously deposited ITO layer which buries the doped ZnO layer;
S24) forming a photoresist protective layer on the ITO layer, etching the ITO layer and the doped ZnO layer on a step region of the epitaxial wafer which are not protected by the photoresist, and removing the photoresist protective layer; and
S25) forming a positive electrode of the semiconductor light emitting device on a current diffusion layer constituted by the ITO layer and the doped ZnO layer, and forming a negative electrode of the semiconductor light emitting device on the step region of the epitaxial wafer.

With the method for fabricating the semiconductor light emitting device according to an embodiment of the present disclosure, the roughening of the ITO layer is completed during the process of forming the ITO layer. The method for roughening the ITO layer belongs to an in situ roughening method, and a product does not need to be transferred onto other apparatuses for roughening, thus shortening the production cycle and reducing the production cost. That is, additional apparatuses and materials, for example, a photoresist, a lithography equipment and an ICP equipment which are used during dry etching as well as a corrosion apparatus and a corrosion solution which are used during wet etching, do not need to be used for roughening the ITO layer. Meanwhile, because the corrosion solution does not need to be used, the personal safety of employees may be ensured, thus providing security.

The method for fabricating the semiconductor light emitting device according to an embodiment of the present disclosure will be described below in detail with reference to the drawings.

Particularly, in step S21), an epitaxial wafer comprising a substrate 11, an n-type nitride layer 13, a light emitting layer 14 and a p-type nitride layer 15 which are stacked sequentially is formed by MOCVD (metal-organic chemical vapor deposition). Advantageously, a buffer layer 12 is formed between the substrate 11 and the n-type nitride layer 13, as shown in Fig. 2. A photoresist protective layer having a required pattern is formed by lithography; a part of the p-type nitride layer 15, a part of the light emitting layer 14 and a part of the n-type nitride layer 13 are mesa etched sequentially by the ICP technique; the photoresist protective layer is removed by using a photoresist stripping solution to expose the n-type nitride layer 13 which forms the step region of the epitaxial wafer, as shown in Fig. 3. Finally, an ITO source is heated and evaporated on the epitaxial wafer by a direct current electron gun to form an ITO layer 16, as shown in Fig. 4. The selection of the direct current electron gun and the technique of evaporating the ITO source to form the ITO layer are known to those skilled in the art, and therefore the description thereof will be omitted here.

Particularly, in step S22), after a part of the ITO layer 16 which accounts for 85%-90% of the thickness of the ITO layer 16 is deposited, a doped ZnO source is heated and evaporated by a pulse current electron gun, and a duty ratio of the pulse current of the pulse current electron gun is controlled to deposit a discontinuously arranged doped ZnO layer 17 on the part of the ITO layer 16 during the process of forming the ITO layer 16, in which a deposition rate of the doped ZnO layer 17 is larger than that of the ITO layer 16, as shown in Fig. 5. In one embodiment, the thickness of the ITO layer 16 (i.e., the thickness of the current diffusion layer) is about 285 nanometers to about 290 nanometers. When the thickness of the part of the ITO layer 16 which accounts for 85%-90% of the thickness of the ITO layer 16 is about 250 nanometers to about 260 nanometers, the pulse current electron gun is turned on to heat and evaporate the doped ZnO source, and the duty ratio of the pulse current of the pulse current electron gun is controlled to deposit a discontinuously arranged doped ZnO layer 17 on the part of the ITO layer 16.

During the process of depositing the doped ZnO layer 17, the circuit of the pulse current electron gun to is controlled to open or close rapidly by controlling the duty ratio of the pulse current of the pulse current electron gun. Therefore, the growth of a doped ZnO material mainly comprises discontinuous growth, so as to avoid continuous growth of the doped ZnO material and achieve discontinuous deposition of the doped ZnO material. As a result, the preparation of the discontinuously arranged doped ZnO layer 17 may be completed. In one embodiment, the growth of a doped ZnO material mainly comprises island growth.

In one embodiment, the duty ratio of the pulse current is about 20% to about 30%. In one embodiment, the thickness of the doped ZnO layer 17 is about 10 nanometers to about 15 nanometers, thus achieving the roughening of the ITO layer 16. If the thickness of the doped ZnO layer 17 is larger than about 15 nanometers, the light extraction efficiency of the whole current diffusion layer may be reduced. If the thickness of the doped ZnO layer 17 is smaller than about 10 nanometers, the roughening of the ITO layer 16 may not be achieved.

Meanwhile, during the process of depositing the doped ZnO layer 17, the deposition rate of the doped ZnO layer 17 is larger than that of the ITO layer 16, that is, the ITO layer 16 is deposited by the direct current electron gun at a low speed, and the doped ZnO layer 17 is deposited by the pulse current electron gun at a high speed, thus ensuring that the doped ZnO layer 17 is effectively buried in the ITO layer 16. Meanwhile, during the process of depositing the doped ZnO layer 17, the ITO layer 16 is still deposited by the direct current electron gun at a low speed, thus better ensuring that the doped ZnO layer 17 is buried in the ITO layer 16. In one embodiment, the deposition rate of the ITO layer 16 formed by the direct current electron gun is about 0.5 Å/s to about 1.2 Å/s, and the deposition rate of the doped ZnO layer 17 formed by the pulse current electron gun is about 20 Å/s to about 30 Å/s.

In one embodiment, the doped ZnO source is at least one material selected from the group consisting of indium doped zinc oxide, gallium doped zinc oxide, aluminum doped zinc oxide, and a mixture of indium oxide and zinc oxide. Because the conductivity of these materials is substantially equivalent to the conductivity of ITO, when current diffusion layer is formed from ITO and at least one of these materials, the current may diffuse uniformly. Meanwhile, these materials and ITO are both transparent compounds, and the refractive index of these materials and the refractive index of ITO are approximate, which are both about 2.0. Therefore, light may not be easily refracted when penetrating through the ITO layer 16 and the doped ZnO layer 17, thus reducing the loss of light.

Particularly, in step S23), after the doped ZnO layer 17 is deposited, the ITO source is further heated and evaporated by the direct current electron gun to continue depositing a continuously deposited ITO layer 16 which buries the doped ZnO layer 17. In fact, in step S23), by continuously depositing the ITO layer 16, the doped ZnO layer 17 is completely buried in the ITO layer 16, so that there is a height difference between an ITO region in which the doped ZnO material is buried and another ITO region without the doped ZnO material. Therefore, the unevenness of the whole surface of the ITO layer 16 may be achieved, that is, the roughening of the ITO layer 16 may be achieved. In one embodiment, the thickness of the continuously deposited ITO layer 16 is about 15 nanometers to about 20 nanometers. It would be appreciated by those skilled in the art that the thickness of the continuously deposited ITO layer 16 is not limited to this, but may be varied, provided that the doped ZnO layer 17 is completely buried in the ITO layer 16.

Particularly, in step S24), a photoresist protective layer on the ITO layer is formed, the ITO layer 16 and the doped ZnO layer 17 on a step region of the epitaxial wafer which are not protected by the photoresist are etched, and the photoresist protective layer is removed by using a photoresist stripping solution, as shown in Fig. 7.

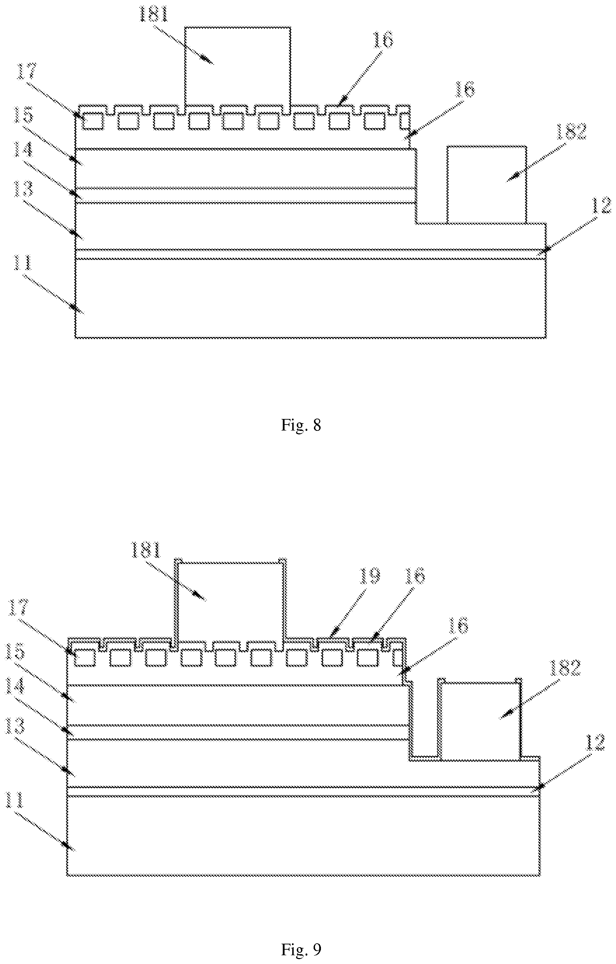

Particularly, in step S25), a positive electrode 181 (i.e., a P electrode) of the semiconductor light emitting device is formed on a current diffusion layer constituted by the ITO layer 16 and the doped ZnO layer 17, and a negative electrode 182 (i.e., an N electrode) of the semiconductor light emitting device is formed on the step region of the epitaxial wafer, as shown in Fig. 8. The positive electrode 181 and the negative electrode 182 are both formed by depositing a metal. In one embodiment, the metal may be one of chromium (Cr)/platinum (Pt)/gold (Au)/nickel (Ni)/gold (Au), and titanium (Ti)/aluminum (Al)/titanium (Ti)/gold (Au).

After step S25), the method for fabricating the semiconductor light emitting device further comprises: depositing a passivation layer 19 on a region of the semiconductor light emitting device except regions of the positive and negative electrodes 181, 182, as shown in Fig. 9, thus protecting the region of the semiconductor light emitting device except regions of the positive and negative electrodes 181, 182 from physical damage and preventing current leakage caused by electrostatic adsorption.

## Claims

1. A method for forming a current diffusion layer in a semiconductor light emitting device, comprising:
S11) heating and evaporating an ITO source on an epitaxial wafer by a direct current electron gun to form an ITO layer (16);
**characterized in that** the method further comprises:
S12) after a part of the ITO layer (16) which accounts for 85%-90% of the thickness of the ITO layer (16) is deposited, heating and evaporating a doped ZnO source by a pulse current electron gun, and controlling a duty ratio of the pulse current of the pulse current electron gun to deposit a discontinuously arranged doped ZnO layer (17) on the part of the ITO layer (16) during the process of depositing the ITO layer, wherein a deposition rate of the doped ZnO layer (17) is larger than that of the ITO layer (16); and
S13) after the doped ZnO layer (17) is deposited, further heating and evaporating the ITO source by the direct current electron gun to continue depositing a continuously deposited ITO layer (16) which buries the doped ZnO layer (17).

2. The method according to claim 1, wherein the thickness of the part of the ITO layer which accounts for 85%-90% of the thickness of the ITO layer is about 250 nanometers to about 260 nanometers.

3. The method according to claim 1, wherein the duty ratio of the pulse current is about 20% to about 30%.

4. The method according to claim 1, wherein the thickness of the doped ZnO layer is about 10 nanometers to about 15 nanometers.

5. The method according to claim 1, wherein the deposition rate of the ITO layer formed by the direct current electron gun is about 0.5 Å/s to about 1.2 Å/s.

6. The method according to claim 1, wherein the deposition rate of the doped ZnO layer formed by the pulse current electron gun is about 20 Å/s to about 30 Å/s.

7. The method according to claim 1, wherein the doped ZnO source is at least one material selected from the group consisting of indium doped zinc oxide, gallium doped zinc oxide, aluminum doped zinc oxide, and a mixture of indium oxide and zinc oxide.

8. The method according to claim 1, wherein the thickness of the continuously deposited ITO layer is about 15 nanometers to about 20 nanometers.

9. A method for fabricating a semiconductor light emitting device, wherein a current diffusion layer is formed in accordance with the process of clam 1 and thereafter the following steps are performed:
S24) forming a photoresist protective layer on the ITO layer (16), etching the ITO layer (16) and the doped ZnO layer (17) on a step region of the epitaxial wafer which are not protected by the photoresist, and removing the photoresist protective layer; and
S25) forming a positive electrode (181) of the semiconductor light emitting device on a current diffusion layer constituted by the ITO layer (16) and the doped ZnO layer (17), and forming a negative electrode (182) of the semiconductor light emitting device on the step region of the epitaxial wafer.

10. The method according to claim 9, after step S25), further comprising:
depositing a passivation layer (19) on a region of the semiconductor light emitting device except regions of the positive and negative electrodes (181, 182).

11. The method according to claim 9, wherein the epitaxial wafer comprises a substrate (11), an n-type nitride layer (13), a light emitting layer (14) and a p-type nitride layer (15) which are stacked sequentially; and a part of the p-type nitride layer (15), a part of the light emitting layer (14) and a part of the n-type nitride layer (13) are etched sequentially to expose the n-type nitride layer (13) which forms the step region of the epitaxial wafer.

## Patentansprüche

1. Verfahren zur Bildung einer Stromdiffusionsschicht in einer lichtemittierenden Halbleitervorrichtung, enthaltend:
S11) Wärmen und Verdampfen einer ITO-Quelle auf einem epitaxialen Wafer durch eine Direktstrom-Elektronenkanone, zur Bildung einer ITO-Schicht (16),
**dadurch gekennzeichnet, dass** das Verfahren weiterhin enthält:
S12) nach Niederschlagen eines Teils der ITO-Schicht (16), was 85 bis 90 % der Dicke der ITO-Schicht (16) ausmacht, Erwärmen und Verdampfen einer dotierten ZnO-Quelle durch eine Pulsstrom-Elektronenkanone und Steuern einer Einschaltdauer des Pulsstromes der Pulsstrom-Elektronenkanone, zum Niederschlagen einer diskontinuierlich angeordneten dotierten ZnO-Schicht (17) auf dem Teil der ITO-Schicht (16) während des Verfahrens zum Niederschlagen der ITO-Schicht, worin eine Niederschlagungsrate der dotierten ZnO-Schicht (17) größer ist als die der ITO-Schicht (16); und
S13) nach Niederschlagen der dotierten ZnO-Schicht (17) weiteres Erwärmen und Verdampfen der ITO-Quelle durch Direktstrom-Elektronenkanone, zum Fortsetzen des Niederschlagens einer kontinuierlich niedergeschlagenen ITO-Schicht (16), die die dotierte ZnO-Schicht (17) darin verborgen aufweist.

2. Verfahren gemäß Anspruch 1, worin die Dicke des Teils der ITO-Schicht, die 85 bis 90 % der Dicke der ITO-Schicht ausmacht, etwa 250 bis etwa 260 nm ist.

3. Verfahren gemäß Anspruch 1, worin die Einschaltdauer des Pulsstroms etwa 20 bis etwa 30 % ist.

4. Verfahren gemäß Anspruch 1, worin die Dicke der dotierten ZnO-Schicht etwa 10 bis etwa 15 nm ist.

5. Verfahren gemäß Anspruch 1, worin die Niederschlagsrate der ITO-Schicht, gebildet durch die Direktstrom-Elektronenkanone, etwa 0,5 bis etwa 1,2 Å/s ist.

6. Verfahren gemäß Anspruch 1, worin die Niederschlagsrate der dotierten ZnO-Schicht, gebildet durch Pulsstrom-Elektronenkanone, etwa 20 bis etwa 30 Å/s ist.

7. Verfahren gemäß Anspruch 1, worin die dotierte ZnO-Quelle zumindest ein Material ist, ausgewählt aus der Gruppe, bestehend aus Indium-dotiertem Zinkoxid, Gallium-dotiertem Zinkoxid, Aluminium-dotiertem Zinkoxid und einer Mischung von Indiumoxid und Zinkoxid.

8. Verfahren gemäß Anspruch 1, worin die Dicke der kontinuierlich niedergeschlagen ITO-Schicht etwa 15 bis etwa 20 nm ist.

9. Verfahren zur Herstellung einer lichtemittierenden Halbleitervorrichtung, worin eine Stromdiffusionsschicht entsprechend dem Verfahren gemäß Anspruch 1 gebildet ist und danach die folgenden Schritte durchgeführt werden:
S24) Bilden einer Fotoresist-Schutzschicht auf der ITO-Schicht (16), Ätzen der ITO-Schicht (16) und der dotierten ZnO-Schicht (17) auf einem Stufenbereich des epitaxialen Wafers, der nicht durch das Fotoresist geschützt ist, und Entfernen der Fotoresist-Schutzschicht, und
S25) Bilden einer positiven Elektrode (181) der lichtemittierenden Halbleitervorrichtung auf einer Stromdiffusionsschicht, konstituiert durch die ITO-Schicht (16) und die dotierte ZnO-Schicht (17) und Bilden einer negativen Elektrode (182) der lichtemittierenden Halbleitervorrichtung bei dem Stufenbereich des epitaxialen Wafers.

10. Verfahren gemäß Anspruch 9, weiterhin umfassend nach Schritt S25):
Niederschlagen einer Passivierungsschicht (19) auf einem Bereich der lichtemittierenden Halbleitervorrichtung mit Ausnahme von Bereichen der positiven und der negativen Elektroden (181, 182).

11. Verfahren gemäß Anspruch 9, worin der epitaxiale Wafer ein Substrat (11), eine Nitridschicht (13) vom n-Typ, eine lichtemittierende Schicht (14) und eine Nitridschicht (15) vom p-Typ enthält, die aufeinanderfolgend gestapelt sind; und ein Teil der Nitridschicht (15) vom p-Typ, ein Teil der lichtemittierenden Schicht (14) und Teil der Nitridschicht (13) vom n-Typ aufeinanderfolgend geätzt sind, zum Freisetzen der Nitridschicht (13) vom n-Typ, die den Stufenbereich des epitaxialen Wafers bildet.

## Revendications

1. Procédé de formation d'une couche de diffusion de courant dans un dispositif semi-conducteur émetteur de lumière, comprenant :
S11) chauffer et évaporer une source à ITO sur une plaquette épitaxiale par un canon à électrons à courant continu pour former une couche d'ITO (16) ;
**caractérisé en ce que** le procédé comprend en outre :
S12) après qu'une partie de la couche d'ITO (16) qui compte pour 85 %-90 % de l'épaisseur de la couche d'ITO (16) est déposée, chauffer et évaporer une source à ZnO dopée par un canon à électrons à courant impulsionnel, et commander un rapport cyclique du courant impulsionnel du canon à électrons à courant impulsionnel pour déposer une couche de ZnO dopée (17) agencée de manière discontinue sur la partie de la couche d'ITO (16) durant le processus de dépôt de la couche d'ITO, dans lequel un taux de dépôt de la couche de ZnO dopée (17) est plus grand que celui de la couche d'ITO (16) ; et
S13) après que la couche de ZnO dopée (17) est déposée, chauffer et évaporer davantage la source à ITO par le canon à électrons à courant continu pour continuer à déposer une couche d'ITO (16) déposée de manière continue qui ensevelit la couche de ZnO dopée (17).

2. Procédé selon la revendication 1, dans lequel l'épaisseur de la partie de la couche d'ITO qui compte pour 85 %-90 % de l'épaisseur de la couche d'ITO est d'environ 250 nanomètres à environ 260 nanomètres.

3. Procédé selon la revendication 1, dans lequel le rapport cyclique du courant impulsionnel est d'environ 20 % à environ 30 %.

4. Procédé selon la revendication 1, dans lequel l'épaisseur de la couche de ZnO dopée est d'environ 10 nanomètres à environ 15 nanomètres.

5. Procédé selon la revendication 1, dans lequel le taux de dépôt de la couche d'ITO formée par le canon à électrons à courant continu est d'environ 0,5 Å/s à environ 1,2 Å/s.

6. Procédé selon la revendication 1, dans lequel le taux de dépôt de la couche de ZnO dopée formée par le canon à électrons à courant impulsionnel est d'environ 20 Å/s à environ 30 Å/s.

7. Procédé selon la revendication 1, dans lequel la source à ZnO dopée est au moins un matériau sélectionné parmi le groupe consistant en de l'oxyde de zinc dopé à l'indium, de l'oxyde de zinc dopé au gallium, de l'oxyde de zinc dopé à l'aluminium, et un mélange d'oxyde d'indium et d'oxyde de zinc.

8. Procédé selon la revendication 1, dans lequel l'épaisseur de la couche d'ITO déposée de manière continue est d'environ 15 nanomètres à environ 20 nanomètres.

9. Procédé de fabrication d'un dispositif semi-conducteur émetteur de lumière, dans lequel une couche de diffusion de courant est formée conformément au procédé selon la revendication 1 et ensuite les étapes suivantes sont effectuées :
S24) former une couche de protection photosensible sur la couche d'ITO (16), graver la couche d'ITO (16) et la couche de ZnO dopée (17) sur une région marche de la plaquette épitaxiale qui ne sont pas protégées par la résine photosensible, et enlever la couche de protection photosensible ; et
S25) former une électrode positive (181) du dispositif semi-conducteur émetteur de lumière sur une couche de diffusion de courant constituée par la couche d'ITO (16) et la couche de ZnO dopée (17), et former une électrode négative (182) du dispositif semi-conducteur émetteur de lumière sur la région marche de la plaquette épitaxiale.

10. Procédé selon la revendication 9, après l'étape S25), comprenant en outre :
déposer une couche de passivation (19) sur une région du dispositif semi-conducteur émetteur de lumière excepté des régions des électrodes positive et négative (181, 182).

11. Procédé selon la revendication 9, dans lequel la plaquette épitaxiale comprend un substrat (11), une couche de nitrure de type n (13), une couche émettrice de lumière (14) et une couche de nitrure de type p (15) qui sont empilées séquentiellement ; et une partie de la couche de nitrure de type p (15), une partie de la couche émettrice de lumière (14) et une partie de la couche de nitrure de type n (13) sont gravées séquentiellement pour exposer la couche de nitrure de type n (13) qui forme la région marche de la plaquette épitaxiale.
